Europäisches Patentamt

European Patent Office

Office européen des brevets

(11) Veröffentlichungsnummer: **0 345 682**
**A2**

## EUROPÄISCHE PATENTANMELDUNG

(21) Anmeldenummer: 89110102.4

(51) Int. Cl.⁴: **H05K 7/14**

(22) Anmeldetag: 03.06.89

(30) Priorität: 07.06.88 DE 3819295

(43) Veröffentlichungstag der Anmeldung:
13.12.89 Patentblatt 89/50

(84) Benannte Vertragsstaaten:
AT CH DE ES FR IT LI NL

(71) Anmelder: **Licentia Patent-Verwaltungs-GmbH**
**Theodor-Stern-Kai 1**
**D-6000 Frankfurt/Main 70(DE)**

(72) Erfinder: **Bohnenberger, Willy**
**Goethestrasse 8**
**D-6451 Mainhausen(DE)**
Erfinder: **Börner, Gerhard**
**Spessartstrasse 79**
**D-6453 Klein-Welzheim(DE)**

(74) Vertreter: **Lertes, Kurt, Dr. et al**
**Licentia Patent-Verwaltungs-GmbH**
**Theodor-Stern-Kai 1**
**D-6000 Frankfurt/M 70(DE)**

(54) Baugruppenträger mit in Führungshaltern einsetzbaren Baugruppen.

(57) Gegenstand der Erfindung ist ein Baugruppenträger (1) mit Paaren von Führungshaltern zur Aufnahme von Baugruppen (8), die jeweils Steckverbinderelemente aufweisen (11), die mit korrespondierenden Steckverbinderelementen (13) im Baugruppenträger (1) in einer Endlage der jeweiligen Baugruppe eine mechanisch feste, elektrisch niederohmige Verbindung bilden.

Für das Stecken und Ziehen der Baugruppen (8)
sind Antriebe vorgesehen, die mit den Baugruppen
(8) längs jeweils eines mindestens das Stecken und
Ziehen der Steckverbinderkontakte umfassenden
Wegs verbunden sind. Die Baugruppen (8) sind
beim Stecken und Ziehen längs einer eine genaue
Ausrichtung der Steckverbinderkontakte gewährleistenden Führung verschiebbar.

FIG.1

EP 0 345 682 A2

## Baugruppenträger mit in Führungshalter einsetzbaren Baugruppen

Die Erfindung bezieht sich auf einen Baugruppenträger mit Paaren von Führungshaltern zur Aufnahme von Baugruppen, die jeweils Steckverbinderelemente aufweisen, die mit korrespondierenden Steckverbinderelementen im Baugruppenträger in einer Endlage der jeweiligen Baugruppe mechanisch feste, elektrisch niederohmige Verbindung bilden.

Elektronische Bauelemente, z.B. integrierte oder diskrete Schaltungsbausteine werden auf gedruckten Leiterplatten montiert. Die so gebildeten Baugruppen werden in die Baugruppenträger eingesetzt. Die elektrischen Verbindungen zu benachbarten Baugruppen oder externen Schaltungen werden über die Steckverbinderelemente hergestellt, die jeweils an den Baugruppen und innen an der Rückseite des Baugruppenträgers angebracht sind. Von den Steckverbinderelementen im Inneren des Baugruppenträgers verlaufen Leitungen, z.B. in Form von Leiterbahnen auf einer Rückwandleiterplatte zu anderen Steckverbindern. Baugruppenträger der vorstehend beschriebenen Art sind z.B. aus der DE-OS 18 08 280 oder der Siemens-Zeitschrift 46 (1972) H. 4, Seiten 277 bis 282, bekannt.

Beim Adaptieren von Baugruppen, die vorzugsweise Leiterplatten aufweisen, in Baugruppenträgern müssen folgende Bedingungen erfüllt werden:

a) Die Steck- und Ziehkräfte der Steckverbinder an der jeweiligen Baugruppe und am Baugruppenträger müssen überwunden werden,

b) Die Baugruppe muß gegen ungewollte Trennung der Steckverbinder verriegelt werden.

c) Zur Vermeidung einer falschen Bestückung des Baugruppenträgers müssen die Steckverbinder der Baugruppen codiert sein.

d) Die Baugruppen müssen beim Einsetzen und Herausziehen gleichmäßig bewegt werden, damit Beschädigungen an den Steckverbindern ausgeschlossen werden.

Bekannt ist das Adaptieren der Baugruppen von Hand durch Einschieben der Leiterplatten in Paare von Führungshaltern. Solange die Steckelemente einander nicht berühren, sind für das Einschieben der Baugruppen relativ geringe Kräfte erforderlich. Um die Steckverbinderelemente miteinander zu verbinden, ist eine größere Kraft erforderlich. Insbesondere bei vielpoligen Steckverbindern mit dicht nebeneinander angeordneten Messern von geringem Querschnitt kann es vorkommen, daß die von Hand aufgebrachte Kraft sehr groß ist oder nicht in axialer Richtung der Federn und Messern des Steckverbinders ausgeübt wird. Dabei können die Federn und Messern beschädigt werden, wodurch keine sichere Kontaktgabe mehr gewährleistet ist.

Die Steck- und Ziehkräfte können auch mit Hilfe von Exzenter und Hebeln überwunden werden. Zur Verriegelung der Baugruppen werden Einzel- oder Gesamtverriegelungen in Schraubtechnik verwendet. Zur Codierung sind spezielle Formteile mit ausbrechbaren Elementen vorgesehen.

Der Erfindung liegt die Aufgabe zugrunde, einen Baugruppenträger der eingangs beschriebenen Gattung derart weiterzuentwickeln, daß das Adaptieren und Verriegeln automatisch durchgeführt werden kann.

Die Aufgabe wird erfindungsgemäß dadurch gelöst, daß für das Stecken und Ziehen der Baugruppen Antriebe vorgesehen sind, die mit den Baugruppen längs jeweils eines mindestens das Stecken und Ziehen der Steckverbinderkontakte umfassenden Wegs verbunden sind, und daß die Baugruppen beim Stecken und Ziehen längs einer eine genaue Ausrichtung der Steckverbinderkontakte gewährleistenden Führung verschiebbar sind. Bei dieser Vorrichtung müssen die Baugruppen nur noch zum Teil in den Baugruppenträger eingeschoben bzw. aus diesem herausgezogen werden. Das Ineinanderfügen und Lösen der Steckverbinderkontakte erfolgt mit einer automatisch arbeitenden Vorrichtung, die eine vorgebbare Kraft zum Zusammenstecken und Lösen der Steckverbinderanteile aufbringt. Diese Kraft ist auf einen günstigen Wert eingestellt. Die Steckverbinderkontakte werden beim mehrmaligen Zusammenfügen und Lösen immer mit gleichbleibenden Kräften beansprucht. Hierdurch werden Beschädigungen durch zu hohe Kräfte vermieden. Die von der automatisch arbeitenden Vorrichtung erzeugten Kräfte können der Größe und dem Typ des Steckverbinders sowie der Anzahl und Geometrie der Messer- und Federkontakte ohne Schwierigkeit angepaßt werden. Eine gesonderte Steckund Ziehhilfe, die von Hand betätigt werden muß, erübrigt sich. Ein besonderer Vorteil besteht darin, daß eine sichere Kontaktgabe durch die automatische Herstellung der Verbindung gewährleistet wird.

Bei einer bevorzugten Ausführungsform ist vorgesehen, daß im Baugruppenträger mindestens eine automatische Baugruppeneinzugs- und auswerfvorrichtung angeordnet ist, die ein erstes Schaltelement zur Feststellung einer ersten Position einer Baugruppe vor der Endlage, einen Antriebs- und Mitnehmermechanismus für die Verschiebung der Baugruppe von der ersten Position bis zur Endlage und umgekehrt sowie ein zweites Schaltelement enthält, das die Endlage der Baugruppe erfaßt und den Antriebs- und Mitnehmermechanismus beim Einziehen der Baugruppe abschaltet und beim Auswerfen einschaltet.

Zweckmäßigerweise enthält die automatische Baugruppeneinzugs- und auswerfvorrichtung ein motorisch angetriebenes Schiebeteil, das längs eines Abschnitts des jeweiligen Führungshalterpaares, der dem baugruppenträgerseitigen Steckverbinderelement benachbart ist, bewegbar gelagert ist und einen in eine Ausnehmung der jeweiligen Baugruppe einfügbaren Riegel aufweist. Wenn die Baugruppe mit dem Schieber in die rückwärtige Endlage verschoben, in der der Motor des Schiebers durch Betätigung des zweiten Schaltelements abgeschaltet wird. Der Riegel bleibt vorzugsweise in der Ausnehmung, wodurch eine so feste Halterung der Baugruppe im Baugruppenträger erreicht wird, daß sich vielfach weitere Befestigungselemente, z. B. Schraubbefestigungen an der Frontleiste der Baugruppe, erübrigen.

Zweckmäßig ist es, wenn der Schieber durch eine Gewindespindel mit einem Elektromotor verbunden ist. Über die Steigung der Gewindespindel ist eine Anpassung der auf den Schieber ausgeübten Kraft mit Hilfe des vom Motor erzeugten Drehmoments auf einfache Weise möglich. Darüber hinaus ist die Gewindespindel im Stillstand des Motors selbsthemmend mit dem Schieber verbunden, d. h. bei Ausübung einer Zugkraft von Hand auf die in ihrer Endlage angeordnete Baugruppe dreht sich die Spindel nicht. Deshalb ist ein Herausziehen der Baugruppe von Hand aus dem Baugruppenträger nicht möglich.

Der Riegel wird vorzugsweise durch einen in einer Führung bewegbaren Abschnitt in einer vorgegebenen Stellung zwangsweise in die Ausnehmung eingeschoben.

Die Erfindung wird im folgenden anhand eines in einer Zeichnung dargestellten Ausführungsbeispiels näher beschrieben, aus dem sich weitere Einzelheiten, Merkmale und Vorteile ergeben. Es zeigen

Fig. 1 einen Baugruppenträger mit Baugruppen von oben, teilweise im Schnitt,

Fig. 2 den Baugruppenträger gemäß Fig. 1 im Schnitt längs der Linien I-I,

Fig. 3 eine andere Ausführungsform eines Baugruppenträgers in Seitenansicht,

Fig. 4 eine Vorrichtung zum mechanischen Codieren in Draufsicht.

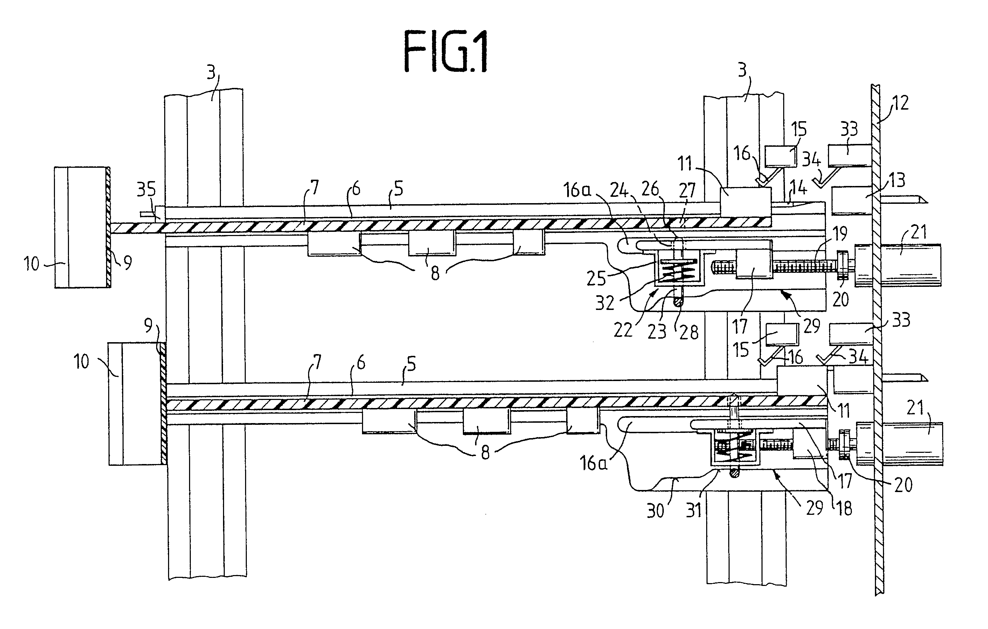

Ein Baugruppenträger 1 enthält Seitenwände 2, von denen in Fig. 1 nur eine sichtbar ist, und vier Profilschienen 3, die je mit einer Stirnseite an den Ecken einer Seitenwand 2 befestigt sind. Mit den Profilschienen 3 sind jeweils Paare von Führungshaltern bzw. Führungsschienen 4, 5 so verbunden, daß die eine Führungsschiene 4 die oberen Profilschienen 3 und die andere Führungsschiene 5 die unteren Profilschienen 3 überbrückt. Die Paare von Führungsschienen 4, 5 sind im Abstand nebeneinander, z. B. in einer genormten Teilung angeordnet, die jeweils Baugruppen gleicher Breite zugeordnet ist.

Die Führungsschienen 4, 5 enthalten Längsnuten 6, die bei beiden Führungsschienen 4, 5 einander zugewandt sind und miteinander fluchten. In die Längsnuten 6 sind Leiterplatten 7 von Baugruppen 8 mit ihren Rändern einschiebbar. Die Baugruppen 8 enthalten auf den Leiterplatten 7 befestigte, nicht näher bezeichnete elektronische bzw. elektrische Bauelemente. An den Frontseiten der Baugruppen 8 sind Frontleisten 9 befestigt, die Griffleisten 10 enthalten.

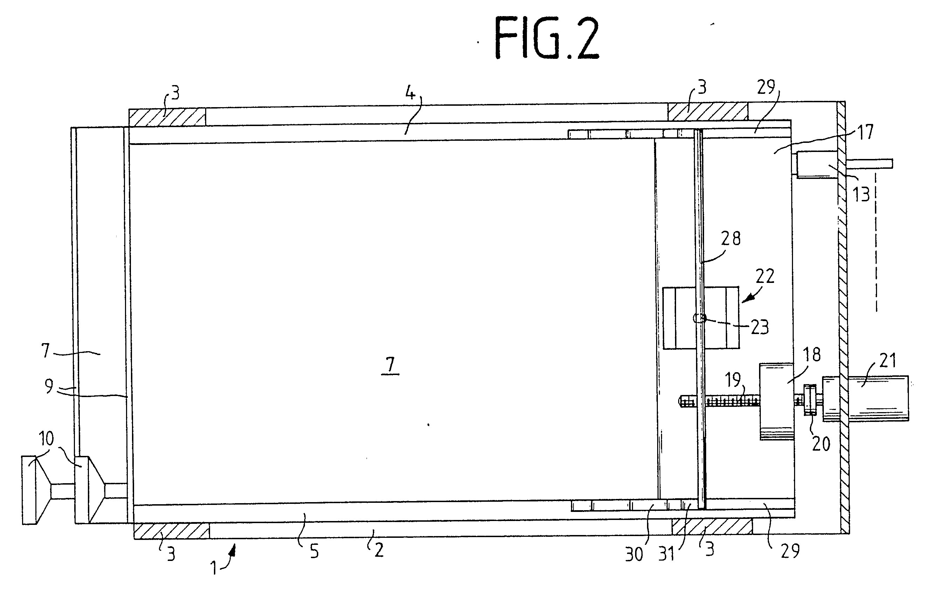

Die rückwärtigen Seiten der Leiterplatten 7 tragen Steckverbinderelemente 11. An der rückwärtigen Seite des Baugruppenträgers 1 ist eine Rückwandleiterplatte 12 befestigt, auf der Steckverbinderelemente 13 angeordnet sind. Bei den Steckverbinderelementen 11 handelt es sich vorwiegend um Messerleisten, während die Steckverbinderelemente 13 Federleisten sind. Jeweils ein Steckverbinderelement 11 einer Leiterplatte 7 ist für die Verbindung mit einem Steckverbinderelement 13 auf der Rückwandleiterplatte 12 vorgesehen, d.h. jeweils zwei Steckverbinderelemente 11, 13 korrespondieren miteinander, wenn die Leiterplatte 7 völlig in die Führungsschienen 4, 5 eingeschoben ist. Die Leiterplatte 7 nimmt dann eine Endlage ein, die in Fig.2 bei einer der Baugruppen 8 dargestellt ist. In dieser Endlage liegt die Frontplatte 9 an den vorderen Profilschienen 3 an.

Die Leiterplatten 7 lassen sich in den Nuten 6 von Hand nur solange relativ leicht verschieben, bis die Steckverbinder miteinander in Eingriff kommen. Zwischen den Messern 14 der Steckverbinderelemente 11 und den nicht näher dargestellten Federn der Steckverbinderelemente 13 sind bestimmte Anpreßkräfte erforderlich, daher ist insbesondere bei hochpoligen Steckverbinderelementen eine relativ große Kraft erforderlich, um die Teile miteinander zu verbinden.

Das Einziehen der Leiterplatten 7 in die Endlage zumindest auf dem Abschnitt, auf dem die Kontakte der Steckverbinderelemente 11, 13 miteinander in Eingriff stehen, wird bei der in Fig.1 und 2 dargestellten Anordnung durch eine Baugruppeneinzugs- und -auswurfvorrichtung selbsttätig durchgeführt, die nachher im einzelnen beschrieben ist. Die Baugruppeneinzugsund -auswurfvorrichtung trennt auch automatisch die Steckverbinderelemente 11, 13.

An einer Stelle im Verschiebeweg der Leiterplatte 7 befindet sich ein Schaltelement 15, z.B. ein Mikroschalter mit einer Fahne 16. Mit dem Schaltelement 15 wird diejenige Position der Leiterplatte 7 erfaßt, an die sich bei weiterer Einwärtsbewegung die Zusammenfügung der Steckverbinderelemente 11, 13 anschließt.

Die Führungshalter 4, 5 weisen zu den Nuten parallele Nuten 16a auf, die sich jedoch nur über ein Stück im rückwärtigen Teil der Führungshalter 4, 5 erstrecken. In den Nuten 16a, die sich bei den Führungshaltern 4, 5 spiegelbildlich gegenüberstehen, sind Schiebeteile 17 bewegbar angeordnet. Die Schiebeteile 17 erstrecken sich als flache Platte zwischen den Nuten 16a der Führungshalter 4, 5 und weisen einen den Leiterplatten 7 abgewandten Vorsprung 18 auf, in dem sich eine Gewindebohrung befindet, die nicht näher dargestellt ist. Die Gewindebohrung hat eine parallel zu den Nuten 6 verlaufende, nicht dargestellte Mittelachse. In der Gewindebohrung ist eine Gewindespindel 19 gelagert, deren Ende über eine Kupplung 20 mit der Welle eines Elektromotors 21 verbunden ist, die in der Rückwandleiterplatte 12 befestigt ist. Der Elektromotor 21, z.B. ein Gleichstrommotor mit Permanentmagneten, ist in der Drehrichtung umschaltbar. Je nach der Drehrichtung des Läufers des Elektromotors 21 bewegt sich das Schiebeteil 17 in den Nuten 16a vor oder zurück.

An den Schiebeteilen 17 ist ein Riegelmechanismus 22 mit einem quer zur Längsachse der Nut 6 verschiebbaren Riegel 23 befestigt. Der Riegel 23 wird in einer Ausnehmung 24 des Schiebeteils 17 und in einer nicht dargestellten Ausnehmung eines Bügels 25 geführt. Die Ausnehmung 24 und die Ausnehmung des Bügels 25 fluchten zueinander.

Der Riegel 23 hat eine Spitze 26, die zum Einfügen in eine Ausnehmung 27 der Leiterplatte 7 bestimmt ist, wenn die Leiterplatte 7 vom Schiebeteil 17 mitgenommen werden soll. Der Riegel steht unter der Vorspannung einer Feder 32, die in Richtung der Leiterplatte 7 eine Kraft ausübt. Das der Leiterplatte 7 abgewandte Ende des Riegels 23 ist mit einer Stange 28 verbunden, deren Enden längs eines Absatzes 29 an den Führungshaltern 4, 5 bewegbar ist. Der Absatz 29 hat zwei Zonen 30, 31, die sich in verschiedenen Abständen zu der Leiterplatte 7 befinden. In der Zone 30 wird der Riegel 23 in einer Lage gehalten, in der die Spitze 26 die Leiterplatte 7 freigibt, d.h. aus der Ausnehmung 27 herausgezogen ist. In der Zone 30 wird das Einfügen der Spitze 26 in die Ausnehmung 27 nicht behindert. Der Beginn der Zone 30 ist auf die Lage des Schaltelements 15 abgestimmt. Ein weiteres Schaltelement 33, das an der Rückwandleiterplatte 12 befestigt ist, stellt z.B. mit einer Fahne 34 die Endlage des Steckverbinderelements 11 fest, wenn dieses mit dem Steckverbinderelement 13 verbunden ist. An jedem Steckkartenplatz befindet sich an der Vorderseite z.B. unterhalb der Frontleiste 9 ein weiterer Schalter 35, mit dem die Baugruppeneinzugs- und -auswurfvorrichtung ein- und ausgeschaltet wird.

Ist die Baugruppeneinzugs- und auswurfvorrichtung eingeschaltet und wird eine von Hand in die Führungshalter 4, 5 eingeschobene Leiterplatte 7 vom Schaltelement 15 festgestellt, dann wird der Motor 33 eingeschaltet, der das Schiebeteil 17 gegen die Rückwandleiterplatte 12 zieht. Dabei verschiebt sich der Riegel 23 gegen die Leiterplatte 7, wobei die Spitze 28 in die Ausnehmung 27 eingreift. Die Leiterplatte 7 wird daher vom Schiebeteil 17 mitgenommen. Auf die Leiterplatte 7 wird eine Kraft ausgeübt, so daß während der Verschiebebewegung des Steckverbinderelements die Messer 14 in die Federkontakte des Steckverbinderelements 13 eingefügt werden. Sobald das Schaltelement 33 die Endlage des Steckverbinderelements 11 erfaßt, wird der Motor 33 abgeschaltet. Wenn die Verbindung zwischen den Steckverbinderelementen 11, 13 gelöst werden soll, wird der Schalter 35 in seine andere Endlage gebracht, wodurch der Motor 33 in umgekehrtem Drehsinn eingeschaltet wird. Über die Spindel 19 und das Schiebeteil 19 sowie den Riegel 23 wird die Leiterplatte 7 nach vorne bewegt, bis das Schaltelement 15 anspricht, wodurch der Motor abgeschaltet und der Riegel 23 aus der Leiterplatte 7 zurückgezogen wird. Die Baugruppe 8 kann dann von Hand leicht aus den Führungshaltern 4, 5 herausgezogen werden.

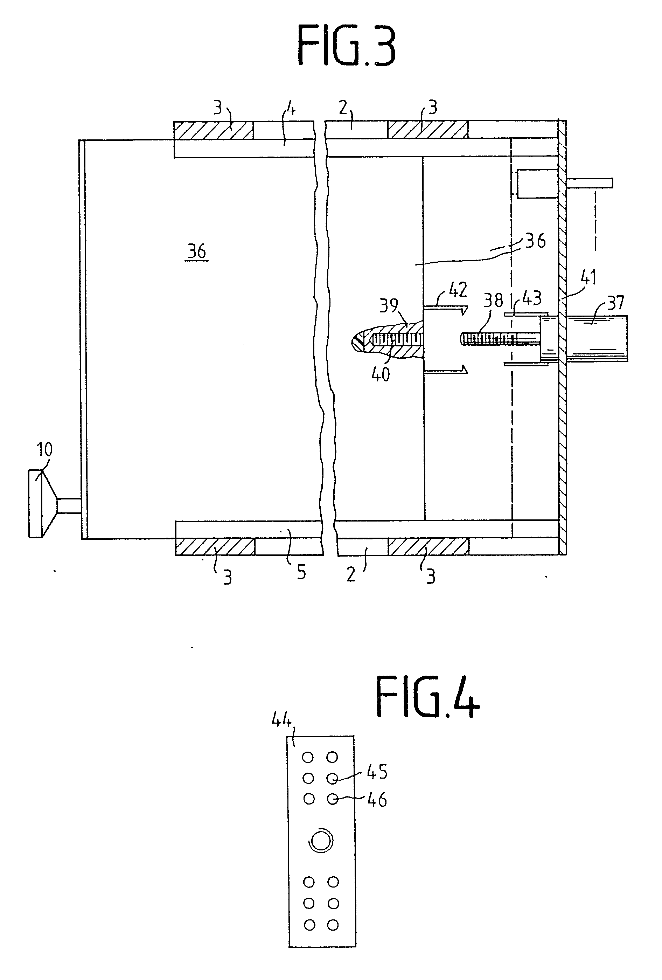

Der in Fig. 3 dargestellte Baugruppenträger entspricht hinsichtlich der Seitenwände, Profilschienen und Führungsschienen sowie der Steckverbinderelemente dem in den Fig. 1 und 2 dargestellten Baugruppenträger. Gleiche Elemente bei den in Fig. 1 bis 3 dargestellten Vorrichtungen sind mit den gleichen Bezugszeichen versehen.

Im rückwärtigen Teil des in Fig. 3 gezeigten Baugruppenträgers befindet sich außerhalb des Verschiebewegs der Leiterplatte 36 einer Baugruppe des Antriebs ein Motor 37 mit einer am Läufer befestigten Zugspindel 38, die in parallel zu den Führungsschienen 5 verläuft. Das freie Ende der Zugspindel 38 ist der vorderen Öffnung des Baugruppenträgers zugewandt.

Mit der Leiterplatte 36 ist ein Lager 39 für die Zugspindel 38 verbunden. Das Lager 39 enhält eine Gewindebohrung 40, die auf die Position der Zugspindel 38 derart abgestimmt ist, daß diese in die Gewindebohrung 40 eingreifen kann. Der Motor 37 ist an einem Träger 41 befestigt. Auf dem Lager 39 sind voreilende, elektrische Stiftkontakte 42 angeordnet, denen vor dem Träger 41 Kontaktelemente 43 entsprechen. Über die Stiftkontakte 42 und die Kontaktelemente 43 wird bei Berührung eine Meldung erzeugt, daß die Verbindung zwischen den Steckverbinderelementen hergestellt ist. In der Griffleiste 10 des Baugruppenträgers befindet sich ein Schalter durch den die Drehrichtung des Motors 37 und dessen Einschaltung gesteuert wird.

Beim Einsetzen der Baugruppe in den Baugruppenträger wird der Schalter in der Griffleiste betätigt, um den Motor 37 mit einer bestimmten Drehrichtung einzuschalten, in der die Leiterplatte 36 gegen die Rückseite des Baugruppenträgers gezogen wird. Sobald das Lager 39 von Hand zur Spitze der Zugspindel 38 verschoben worden ist, greift die Zugspindel 37 in die Gewindebohrung 40 ein und zieht die Baugruppe mit gleichmäßiger Geschwindigkeit in Richtung der Rückseite des Baugruppenträgers. Hierbei werden die auf der Baugruppe und am Baugruppenträger angeordneten Steckverbinderteile miteinander verbunden. Wenn die Stiftkontakte 42 die Kontakte 43 berühren, wird der Motor 37 abgeschaltet. Die Baugruppe wird unverlierbar im Baugruppenträger gehalten, da die Zugspindel 38 nicht ohne Einschalten des Motors aus ihrer Verbindung mit dem Lager 39 gelöst werden kann. Ein ungewolltes Lösen der Verbindung zwischen Baugruppe und Baugruppenträger ist daher nicht möglich, d. h. die Baugruppe wird automatisch verriegelt.

Zur mechanischen Codierung der Baugruppe kann ein Gewinde mit einer bestimmten Gangrichtung, d. h. ein Rechts- oder Linksgewinde verwendet werden. Weiterhin können Gewinde mit verschiedenen Steigungen und/oder Durchmessern eingesetzt werden. Eine Verbindung zwischen Baugruppe und Baugruppenträger läßt isch nur Herstellen, wenn die Zugspindel 38 und das Innengewinde 40 zueinander passen.

Die Steckverbinderteile an der Baugruppe und am Baugruppenträger können an die automatische Verriegelung insofern angepaßt werden, als in ihrer Mitte jeweils das Innengewinde 40 und ein Durchlaß für die Zugspindel 38 vorgesehen wird.

Es ist auch eine mechanische Codierung mit Stiften und Buchsen möglich, wie sie in Fig. 4 dargestellt ist. Das Lager 40 kann Buchsen, z. B. die Buchsen 44, 45, 46, aufweisen, in die vom Träger 41, der ein Gegenlager bildet, lösbare befestigte Stifte eingreifen, wenn die Buchsen 44, 45, 46 nicht durch Stifte blockiert sind. Auf diese Weise können Kombinationen von freien Buchsen und Stiften gebildet werden, durch die nur bestimmte Baugruppen an den dafür vorgesehenen Baugruppenplätzen adaptiert werden können.

Die Stifte und Buchsen können elektrisch leitend ausgebildet sein, um über bestimmte Stromkreise Steuervorgänge auszulösen. Beispielsweise werden Stifte und Buchsen für den Entriegelungsbefehl ausgenutzt.

Die Zugspindel 38 und das Lager 39 sorgen für eine genaue Führung der Steckverbinderkontakte während des Steckens und Ziehens.

## Ansprüche

1. Baugruppenträger mit Paaren von Führungshaltern zur Aufnahme von Baugruppen, die jeweils Steckverbinderelemente aufweisen, die mit korrespondierenden Steckverbinderelementen im Baugruppenträger in einer Endlage der jeweiligen Baugruppe eine mechanisch feste, elektrisch niederohmige Verbindung bilden,
**dadurch gekennzeichnet,**
daß für das Stecken und Ziehen der Baugruppen Antriebe vorgesehen sind, die mit den Baugruppen längs jeweils eines mindestens das Stecken und Ziehen der Steckverbinderkontakte umfassenden Wegs verbunden sind, und daß die Baugruppen beim Stecken und Ziehen längs einer eine genaue Ausrichtung der Steckverbinderkontakte gewährleistenden Führung verschiebbar sind.

2. Baugruppen nach Anspruch 1,
**dadurch gekennzeichnet,**
daß im Baugruppenträger (1) mindestens eine automatische Baugruppeneinzugs- und auswerfvorrichtung angecrdnet ist, die ein erstes Schaltelement (15) zur Feststellung einer ersten Position einer Baugruppe (8) vor der Endlage, einen Antriebs- und Mitnehmermechanismus für die Verschiebung der Baugruppe (8) von der ersten Position zu der Endlage und umgekehrt sowie ein zweites Schaltelement (33) enthält, daß die End lage der Baugruppe (8) erfaßt und den Antriebs- und Mitnehmermechanismus beim Einziehen der Baugruppe (8) abschaltet und beim Auswerfen einschaltet.

3. Baugruppenträger nach Anspruch 1 oder 2,
**dadurch gekennzeichnet,**
daß die Baugruppeneinzugs- und auswerfvorrichtung ein motorisch angetriebenes Schiebeteil (17) enthält, das längs eines Abschnitts des jeweiligen Führungshalterpaars (4, 5), der dem baugruppenträgerseitigen Steckverbinderelement (13) benachbart ist, bewegbar gelagert ist und einen in eine Ausnehmung (27) der jeweiligen Baugruppe (8) einfügbaren Riegel (23) aufweist.

4. Baugruppenträger nach einem oder mehreren der vorhergehenden Ansprüche, **dadurch gekennzeichnet,**
daß das Schiebeteil (17) durch eine Gewindespindel (19) mit einem Elektromotor (21) verbunden ist.

5. Baugruppenträger nach einem oder mehreren der vorhergehenden Ansprüche, **dadurch gekennzeichnet,**
daß auf dem Baugruppenträger ein Lager (39) mit einem Innengewinde (40) angeordnet ist, in das eine in den Verschiebeweg ragende Zugspindel (38) eingreift, die mit einem Motor (37) an der Rückseite des Baugruppenträgers Verbunden ist.

6. Baugruppenträger nach einem oder mehreren der vorhergehenden Ansprüche, **dadurch gekennzeichnet,**
daß das Lager (40) das Steckverbinderelement im Baugruppenträger einen Durchlaß für die Zugspindel (38) hat.

7. Baugruppenträger nach einem oder mehreren der vorhergehenden Ansprüche, **dadurch gekennzeichnet,**
daß an einem Träger (41) Kontakte (43) angeordnet sind, die nach dem Einsetzen der Baugruppe in den Baugruppenträger über an der Baugruppe angeordnete Stiftkontakte (42) den Antrieb abschalten.

8. Baugruppenträger nach einem oder mehreren der vorhergehenden Ansprüche, **dadurch gekennzeichnet,**
daß an der Baugruppe oder am Baugruppenträger Stifte und Buchsen vorgesehen sind ,die zur Herstellung der Verbindung der Steckverbinderelemente miteinander korrespondieren.

9. Baugruppenträger nach einem der Ansprüche 1 bis 7, **dadurch gekennzeichnet,**
daß zur mechanischen Codierung von Baugruppe und Baugruppenträger unterschiedlich ausgebildete Zugspindeln (38) und Innengewinde vorgesehen sind.

10. Baugruppenträger nach einem der vorhergehenden Ansprüche, **dadurch gekennzeichnet,**
daß in einer Griffleiste (10) der Baugruppe ein Schalter für die Einschaltung des Antriebs vorgesehen ist.

FIG1

# FIG.2

EP 0 345 682 A2

F 88/4

# FIG.3

# FIG.4

F 88/4